# EUROPEAN PATENT SPECIFICATION

(11) **EP 3 352 365 B1**
(45) Date of publication and mention of the grant of the patent: **04.09.2019**
(21) Application number: 17305063.4
(22) Date of filing: 20.01.2017
(51) Int. Cl.: H02N 1/08, B81B 3/00

(54) **MINIATURE KINETIC ENERGY HARVESTER FOR GENERATING ELECTRICAL ENERGY FROM MECHANICAL VIBRATIONS**
KINETISCHER MINIATUR-ENERGIEGEWINNER ZUR ERZEUGUNG ELEKTRISCHER ENERGIE AUS MECHANISCHEN SCHWINGUNGEN
RÉCUPÉRATEUR D'ÉNERGIE CINÉTIQUE MINIATURE POUR GÉNÉRER DE L'ÉNERGIE ÉLECTRIQUE À PARTIR DE VIBRATIONS MÉCANIQUES

(43) Date of publication of application: 25.07.2018
(73) Proprietor: Chambre de Commerce et d'Industrie de Région Paris Ile de France (ESIEE Paris), 93160 Noisy Le Grand (FR)
(72) Inventor: BASSET, Philipe, 94120 Fontenay-sous-Bois (FR); LU, Yingxian, 77600 Bussy Saint-Georges (FR)
(74) Representative: Regimbeau

(56) References cited:
- WO-A1-2008/074538
- DE-A1-102007 033 002

## Description

### FIELD OF THE INVENTION

The invention relates to a miniature kinetic energy harvester for generating electrical energy from mechanical vibrations.

### PRIOR ART

Vibration energy harvesters (VEH) are devices that capture vibration energy from the environment and convert it to useful electrical form.

VEH have been recently considered as an interesting alternative to common electrical sources, such as electrochemical batteries or fuel cells, because they are able to operate for very long time without maintenance. Because of their extended life-time, VEH are particularly contemplated for delivering electrical energy to systems requiring low power: such as wireless sensors, RFID tags or medical devices intended to be implanted in the body.

Most miniature VEH having dimensions below 1 centimeter are only capable of operating at fixed frequencies of several hundred of hertz. Indeed, the maximum electrical power, which may be generated by such inertial devices, depends on the matching of the frequency of the mechanical vibrations they are subjected to and the resonance frequency of their transducer. This maximum electrical power drops dramatically at low frequency.

However, mechanical vibrations from natural and artificial sources are inconsistent and mostly located in below 100 Hz.

Document WO 2016/113199 from the applicant discloses a low frequency electrostatic miniature kinetic energy harvester comprising a movable element, a support and a capacitive transducer. The capacitive transducer comprises a capacitor having two interdigitated comb-shaped electrodes. The oscillations of the first electrode relative to the second electrode cause variation of the gap existing between the fingers of the two comb-shaped electrodes, thus causing variation of the capacitance of the capacitor of the transducer and the conversion of the oscillations into an electrical signal.

In order to improve the output power of a capacitive vibration energy harvester (VEH), a major method is to increase its ratio of capacitance variation η=Cmax/Cmin, where Cmax and Cmin are maximum and minimum capacitance respectively. Theoretically, the classic interdigitated combs are capable of achieving a larger capacitance variation than overlapping structure, because the minimum gap between electrodes in gap-closing structure can be much smaller than the minimum dimension confined by the fabrication process.

However, the gap-closing behavior of the capacitive transducer, where the capacitance variation is obtained by the variation of the gap between the electrodes of the transducer due to the external acceleration, is a highly lossy phenomenon at atmospheric pressure. This comes from the pinching of air between the electrodes that leads to high damping.

The air damping effect in these devices is a major factor that prevents the structure to reach a small gap (i.e. a large Cmax). The output power of gap-closing VEHs is thus limited, especially when the device works with low-frequency vibrations through impact-based frequency up-conversion mechanism.

Further prior art document US 2008/074538 A1 discloses all the features of the preamble of claim 1.

### SUMMARY OF THE INVENTION

Accordingly, one aim of the invention is to provide a miniature kinetic energy harvester for generating electrical energy, with an improved design for the electrodes that drastically reduces the air damping and consequently increases the harvested power at atmospheric pressure, in order to avoid the use of a vacuum package.

Another aim of the invention is to provide a miniature kinetic energy harvester which keeps a good capacitance change and a good maximal capacitance per unit area. As a matter of fact the energy conversion is directly related to the importance of the ratio Cmax/Cmin (with Cmax representing the maximal capacitance and Cmin the minimal capacitance of the variable capacitance).

Another aim of the invention is to provide a miniature kinetic energy harvester which may be fabricated as a microelectromechanical system (MEMS) using batch fabrication technologies generally used for semiconductor devices.

The invention relates to a miniature kinetic energy harvester for generating electrical energy, comprising:
- a support, a movable element, at least one spring mounted between the movable element and the support so that the movable element may be brought into oscillation relative to the support according to at least one first direction of oscillation,
- at least one electrostatic transducer, arranged between the movable element and the support,
the electrostatic transducer having a first comb-shaped electrode fixed to the support and interdigitated with a second comb-shaped electrode fixed to the movable element,
the first fingers of the first comb-shaped electrode and the second fingers of the second comb-shaped electrode being alternatively arranged.

According to the invention, at least some of the first fingers and some of the second fingers comprise :
- teeth on one finger side, said teeth extending parallel to said first direction of oscillation,
- a flat surface on the opposite finger side,
and wherein these first fingers and these second fingers are disposed such that in an electrostatic transducer :
- the teeth of these first fingers are interdigitated with the teeth of these second fingers to form capacitors between said first and second fingers, called "teeth capacitors",
- the flat surfaces of these first fingers face the flat surfaces of these second fingers to form capacitors between said first and second fingers, called "flat capacitors",

in order to generate electrical energy with teeth capacitors and flat capacitors by variation of the capacitance of the miniature kinetic energy harvester.

The miniature kinetic energy harvester may also have the following features, taken alone or in combination:
- the teeth are aerodynamically shaped to reduce air damping dissipation when the teeth of the first fingers of the first comb-shaped electrode come closer to the teeth of the second fingers of the second comb-shaped electrode ;
- the movable element being displaced between two positions, the teeth of the first fingers and the teeth of the second fingers are disposed in the energy harvester such that 50% of teeth capacitors and 50% of flat capacitors control the variation of the capacitance of the miniature kinetic energy harvester , in each of the two positions of the movable element in regard to the support;
- the miniature kinetic energy harvester comprises two electrostatic transducers, a first transducer disposed on one edge of the movable element and a second transducer disposed on the opposite edge of the movable element, said both edges of the movable element being parallel to the first direction of oscillation ;
- the first fingers and the second fingers extend perpendicularly relative to the direction of oscillation ;
- for the movable element, the teeth of the second fingers of the first transducer are oriented in a first sense and the teeth of the second fingers of the second transducer are oriented in a second sense, opposite to the first sense, and for the support, the teeth of the first fingers of the first transducer are oriented in said second sense and the teeth of the first fingers of the second transducer are oriented in said first sense, in order to have 50% of teeth capacitors and 50 % of flat capacitors in the first sense Xa and in the second sense Xb of the oscillation of the movable element;
- for the movable element, the teeth of the second fingers of the first transducer are oriented in the same first sense as the teeth of the second fingers of the second transducer and for the support, the teeth of the first fingers of the first transducer are oriented in the same second sense, opposite to the first sense, as the teeth of the first fingers of the second transducer, in order to have 100% of teeth capacitors (8) in said first sense of oscillation of the movable element and 100% of flat capacitors in said second sense of oscillation of the movable element;
- the teeth have the shape of a triangle, a trapezoid, a rectangle or a bump ;
- the triangle or the trapezoid is isosceles and the angle between the symmetrical axis of the teeth and one of its isosceles sides is comprised between 5° and 60° ;
- the triangle or the trapezoid is isosceles and the angle between the symmetrical axis of the teeth and one of its isosceles sides is comprised between 22° and 30° ;
- the transducer is a MEMS transducer;
- the support surrounds the movable element;
- the harvester comprises also additional fingers with teeth on each side of the additional finger, and/or additional fingers with flat surfaces on each side of the additional finger;
- the harvester comprises also additional fingers with teeth and flat surface on the same side of the additional finger;
- for the movable element, the teeth of the second fingers of the first transducer are oriented in a first sense and the teeth of the second fingers of the second transducer are oriented in a second sense, opposite to the first sense, and for the support, the teeth of the first fingers of the first transducer are oriented in said second sense and the teeth of the first fingers of the second transducer are oriented in said first sense, in order to have x% of teeth capacitors and y % of flat capacitors in the first sense Xa and in the second sense Xb of the oscillation of the movable element, with x and y taking a value in the interval of 0% to 100%, and the sum of x and y is equal to 100% for the energy harvester;
the movable element being displaced between two positions, the teeth of first fingers and the teeth of the second fingers are disposed in the energy harvester such that: x% of teeth capacitors and y% of flat capacitors control the variation of the capacitance of the miniature kinetic energy harvester, in each of the two positions of the movable element in regard to the support, and the sum of x and y is equal to 100% for the energy harvester.

### BRIEF DESCRIPTION OF THE DRAWINGS

Figure 1 schematically shows a miniature kinetic energy harvester having a hierarchical interdigitated electrodes transducer according to a first embodiment of the invention, named "model R",
Figure 2 is a detailed view of the miniature kinetic energy harvester of figure 1,
Figure 3a is a schematic view of the miniature kinetic energy harvester of figure 1,
Figure 3b is a schematic view of the miniature kinetic energy harvester of figure 3a in a first position, and figure 3c is a schematic view of the miniature kinetic energy harvester of figure 3a in second position, the harvester oscillating between these two variables positions,
Figure 4 is a schematic view of the miniature kinetic energy harvester according to a second embodiment of the invention, named "model M",
Figures 5A, 5B and 5C are schematic views of different possible shapes of teeth of the miniature kinetic energy harvester of the invention,
Figures 6 and 7 are diagrams showing the influence of the design parameters θ respectively according to the capacitance ratio η, and according to the capacitance ratio ηₚ (with parasitic capacitance) of the two models of miniature kinetic energy harvesters according to the invention and of the model of the prior art, in a fixed comb area (theoretical results), Cmax being the average value of the maximum capacitance on the two senses of movable element displacement, with Cₚₐᵣ=28 pF,
Figures 8 and 9 are diagrams showing respectively the capacitance variations of models G and R of miniature kinetic energy harvesters in air and in vacuum, with the acceleration of 2_{gpeak} at optimal frequencies (135Hz for Model G, 110Hz for Model R),
Figures 10 to 13 are diagrams showing the converted energy per cycle of external excitation vs frequency sweeps respectively for model G in air and in vacuum and for model R in air and in vacuum, with a load resistance of 6.6 MΩ (optimal) and Cₚₐᵣ=28pF, and
Figures 14 to 17 are diagrams showing the transient output of models G and R with 6.6 MΩ load at 2_{gpeak} and 15 Hz respectively in air with bias of 20V, in vacuum with bias of 20V, in air with bias of 30V and in vacuum with bias of 30V.

### DESCRIPTION OF A PREFERRED EMBODIMENT

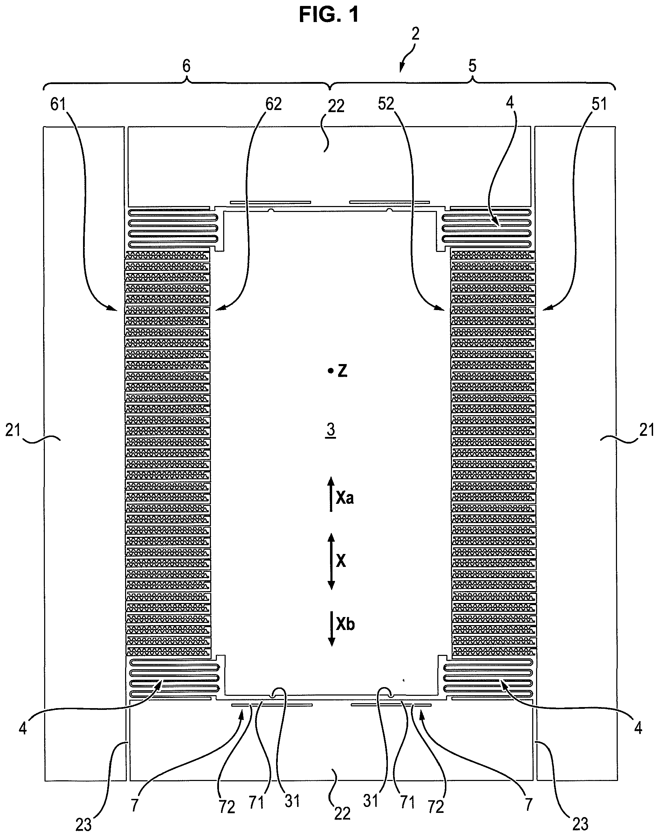

Figure 1 schematically shows a miniature kinetic energy harvester 1 according to a first embodiment of the invention. The miniature kinetic energy harvester 1 comprises a support 2, a movable element 3, springs 4, two electrostatic transducers 5, 6 and elastic stoppers 7.

The support 2 has a shape of a frame and surrounds the movable element 3, the springs 4, the electrostatic transducers 5, 6 and the elastic stoppers 7. The support 2 comprises two longitudinal bars 21 and two transversal bars 22.

The longitudinal bars 21 and the transversal bars 22 are separated from each other by gaps 23 in order to avoid electrical short-circuit between them.

The movable element 3 has a general rectangular shape with four corners.

Preferably, the movable element 3 also comprises four protrusions 31 projecting from transversal sides of the movable element 3.

The miniature kinetic energy harvester 1 comprises four springs 4 suspending the movable element 3 to the support 2.

Each spring 4 has a shape of a serpentine.

Each spring 4 extends between a transversal bar 22 of the support 2 and a corner of the movable element 3.

The springs 4 are arranged so that the movable element 3 is movable relative to the support 2 according to at least one direction of oscillation, named hereafter "first direction of oscillation X". The first direction of oscillation X is parallel to the longitudinal bars 21 of the support 2.

Along this first direction of oscillation X, the movable element 3 may move in a first sense Xa or in a second sense Xb opposite to the first one.

Further, the movable element 3 is also movable relative to the support 2 according to the two other directions Y and Z. Nevertheless, in this embodiment, the movable element 3 moves preferentially in direction X.

The movable element 3 and the springs 4 form a mass-spring system having a natural frequency of oscillation.

The miniature kinetic energy harvester 1 comprises preferably four elastic stoppers 7 arranged between the support 2 and the movable element 3 for limiting travel of the movable element 3 relative to the support 2.

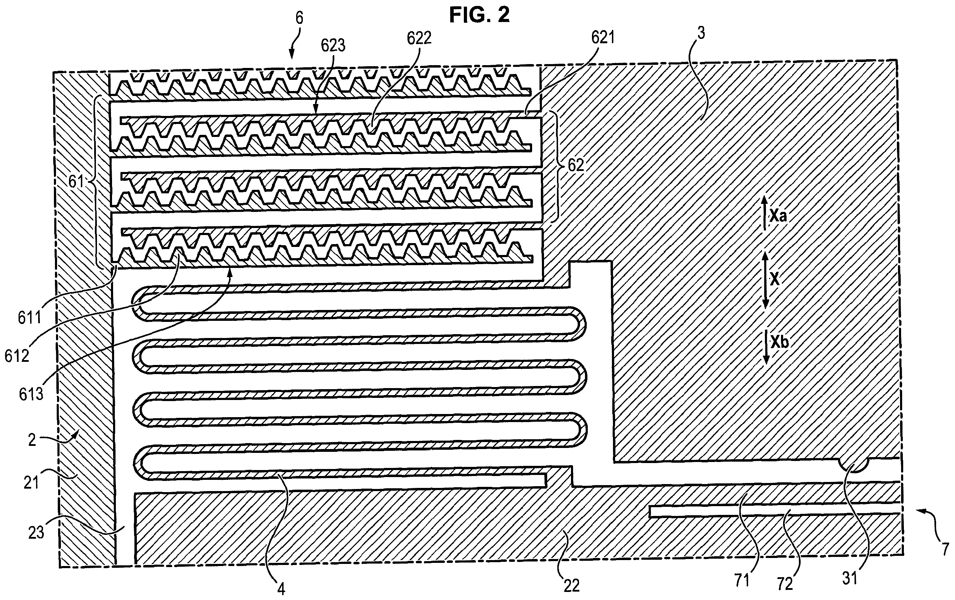

As illustrated on figures 1 and 2, each elastic stopper 7 faces a corresponding protrusion 31 formed on the movable element 3.

Each elastic stopper 6 comprises a beam 71 formed in the support 2. The beam 71 has two ends fixedly connected to the support 2. The beam 71 extends along a direction which is transversal to the first direction X of oscillation of the movable element 3.

The beam 71 may be obtained by providing a slot 72 in the layer of semi-conductor, the slot 72 extending along a side of the transversal bar 22.

When the movable element 3 oscillates relative to the support 2, the protrusion 31 of the movable element 3 may bump into the beam 71.

Each time the protrusion 31 bumps into the beam 71, the protrusion 31 urges the beam 71 towards the support 2, causing the beam 71 to bend elastically.

Because of its elasticity, the beam 71 generates a return force which opposes the movement of the movable element 3. As a result, the elastic stoppers 7 reverse the movable element velocity.

The miniature kinetic energy harvester 1 comprises at least one electrostatic transducer and in the embodiment represented on figure 1, two electrostatic transducers 5 and 6.

Preferably and as represented on figure 1, the first transducer 5 is disposed on one edge of the movable element 3 and the second transducer 6 is disposed on the opposite edge of said element 3. Preferably both edges are parallel to the first direction X of oscillation.

As shown on figure 1, each electrostatic transducer 5 (respectively 6) comprises a first comb or fixed comb 51 (respectively 61) fixedly mounted relative to the support 2 and a second comb or mobile comb 52 (respectively 62) fixedly mounted relative to the movable element 3.

The first comb 51 (respectively 61) has a plurality of parallel fingers 511 (respectively 611) named "first fingers" extending perpendicularly relative to the first direction X of oscillation of the movable element 3.

The second comb 52 (respectively 62) has a plurality of parallel fingers 521 (respectively 621) named "second fingers" also extending perpendicularly relative to the first direction X of oscillation of the movable element 3.

The first comb 51 and the second comb 52 are interdigitated, which means that the second fingers 521 extend in between the first fingers 511 and are alternatively arranged. The fingers 511 and the fingers 521 are spaced from each other by a gap. In this way, the first comb 51 and the second comb 52 form two electrodes of a capacitor.

Similarly the first comb 61 and the second comb 62 are interdigitated and forms two electrodes of a capacitor.

All the fingers are thin lamella extending in a plane perpendicular to the main plane of the movable element 3.

According to the invention, the first fingers 511 (respectively 611) of the first comb-shaped electrode 51 (respectively 61) comprises each: teeth 512 (respectively 612) on one finger side and a flat surface 513 (respectively 613) on the opposite finger side.

Further, the second fingers 521 (respectively 621) of the second comb-shaped electrode 52 (respectively 62) comprises each: teeth 522 (respectively 622) on one finger side and a flat surface 523 (respectively 623) on the opposite finger side.

In each transducer 5 (respectively 6), the teeth are disposed such that the teeth 512 and 522 are interdigitated and the teeth 612 and 622 are interdigitated, to form capacitors 8 called 'teeth capacitors'.

Further, in each transducer 5 (respectively 6), the flat surface 513 of the fingers 511 faces the flat surface 523 of the fingers 521 (respectively the flat surfaces 613 and 623 faces each other), to form capacitors 9 called 'flat capacitors' .

In all the text, the first finger represent the fixed finger (fixed to the support 2), and the second finger represent the mobile finger (fixed to the movable element 3).

This arrangement creates an asymmetric gap-closing structure between the pairs of contiguous fingers, each pair of contiguous fingers forming either a teeth capacitor 8 or a flat capacitor 9. Each pair comprises a first finger and a second finger.

The electrode gap-closing between teeth is different from the electrode gap-closing between flat surfaces because in the first case, the teeth which are more aerodynamic than a flat surface reduce the energy air damping dissipation and allow the air between the fingers to be expelled out as the gap is closing whereas in the second case, the flat surfaces do not reduce the air damping.

Oscillation of the movable element 3 relative to the support 2, in the direction X, in both senses Xa and Xb, causes oscillation of the first comb 51 (or 61) relative to the second comb 52 (or 62) in a direction perpendicular to the fingers, thus causing variation of the gap existing between the fingers 511 (respectively 611) and the fingers 521 (respectively 621), thus causing variation of the capacitance of the capacitor of each transducer 5, 6.

In use, when the miniature kinetic energy harvester 1 is shaken at low frequency (below 60 Hz), the movable element 3 oscillates at the natural frequency of the mass-spring system.

The electrostatic transducers 5, 6 convert oscillation of the first element 3 relative to the support 2 into an output electrical signal which may be further use to supply power to electronic devices.

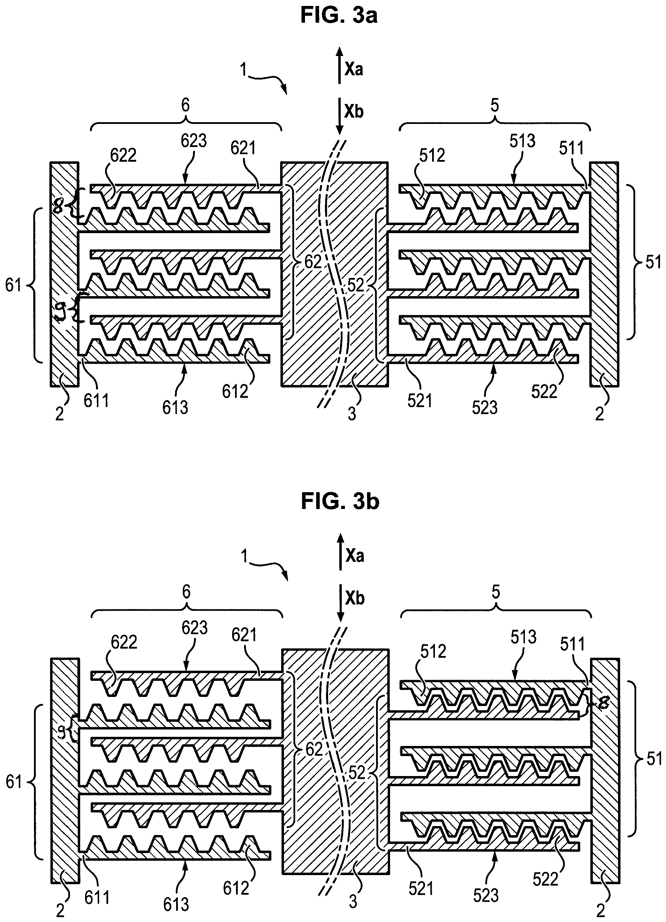

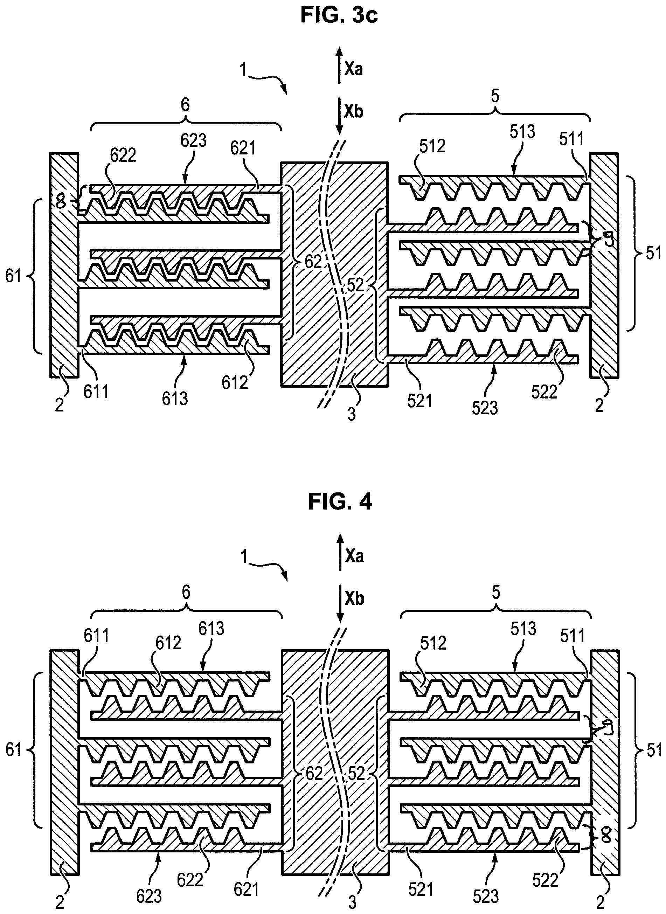

According to one embodiment of the invention illustrated on figure 3a, 3b, 3c, for the movable element 3, the teeth 522 of the second fingers 521 of the first transducer 5 are oriented in the first sense Xa, whereas the teeth 622 of the second fingers 621 of the second transducer 6 are oriented in the second sense Xb, opposite to the first sense Xa. Further, for the support 2, the teeth 512 of the first fingers 511 of the first transducer 5 are oriented in said second sense Xb and the teeth 612 of the first fingers 611 of the second transducer 6 are oriented in said first sense Xa.

Consequently, when the movable element 3 is displaced in the first sense Xa, in the transducer 5, the teeth 521 and 522 are closer, whereas in the transducer 6, the flat surfaces 613 and 623 are closer.

The total capacitance of each transducer is the summary of the teeth capacitor and the flat capacitor.

When the displacement of the movable element is in the sense Xa (no matter what its velocity is), the teeth capacitor 8 in transducer 5 is dominant (meaning that the variation of capacitance of transducer 5 is majorly controlled by teeth capacitor 8); while in transducer 6, flat capacitor 9 is dominant, as illustrated on figures 3b.

The reverse applies when the movable element 3 is displaced in the second sense Xb, (see figure 3c).

In other words, the dominant capacitors in the kinetic energy harvester are 50% teeth capacitors 8 and 50% of flat capacitors 9 in each sense Xa or Xb (meaning that the variation of capacitance of the kinetic energy harvester is controlled 50% by teeth capacitor 8 and 50% by flat capacitor 9, in each sense Xa or Xb) .

In other words, considering the fact that the movable element 3 moves between two positions (these limit positions can vary at each movement of the system) as illustrated on figures 3b and 3c, the teeth of fingers can be disposed such that: 50% of pair of contiguous fingers are dominated by teeth capacitors 8 and 50% of pair of contiguous fingers are dominated by flat capacitors 9 for producing electrical energy, in each of the two positions of the movable element 3 in regard to the support 2, 21, 22.

According to another embodiment of the invention represented on figure 4, in the movable element 3, the teeth 522 of the second fingers 521 of the first transducer 5 are oriented in the same first sense Xa as the teeth 622 of the second fingers 621 of the second transducer 6.

Further, for the support 2, the teeth 512 of the first fingers 511 of the first transducer 5 are oriented in the same second sense Xb, opposite to the first sense Xa, as the teeth 612 of the first fingers 611 of the second transducer 6.

Consequently when the movable element 3 is displaced in the first sense Xa, the dominant capacitors (which produce the most energy) is 100% of teeth capacitors 8. To the contrary, when the movable element 3 is displaced in the second sense Xb, the flat surface 613 are closer to the flat surface 623 in transducer 6 and the flat surfaces 513 and 523 are closer in transducer 5. In this second sense Xb of displacement, the dominant capacitors are 100% of flat capacitors 9.

In another embodiment not represented, x% of pair of contiguous fingers presents teeth capacitors 8 and y% of pair of contiguous fingers presents flat capacitors 9, in each of the two positions of the movable element 3 in regard to the support 2, 21, 22 (the two limit positions of oscillation which can vary to each move of the movable element 3 in regard to the support), with x and y taking a value in the interval to [10%; 90%], with the sum of x and y equal to 100%. This configuration is possible for one, two or more transducers.

It means that:
- when considering one transducer, the variation of capacitance of transducer 5 is majorly controlled by x% of teeth capacitors 8 and y % of flat capacitors 9 of the transducer 5;
- when considering a system with two transducers 5 and 6, the variation of capacitance of the system composed by the transducer 5 and the transducer 6 is majorly controlled by x% of teeth capacitors 8 and y % of flat capacitors 9 of the system.

In other terms, considering that the miniature kinetic energy harvester 1 present two transducers, for the movable element 3, the teeth 522 of the second fingers 521 of the first transducer 5 are oriented in a first sense Xa and the teeth 622 of the second fingers 621 of the second transducer 6 are oriented in a second sense Xb, opposite to the first sense Xa, and for the support 2, 21, 22, the teeth 512 of the first fingers 511 of the first transducer (5) are oriented in said second sense Xb and the teeth 612 of the first fingers 611 of the second transducer 6 are oriented in said first sense Xa, in order to have x% of teeth capacitors 8 and y % of flat capacitors 9 in the first sense Xa and in the second sense Xb of the oscillation of the movable element 3, with x and y taking a value in the interval of 10% to 90%, and the sum of x and y is equal to 100% for the system comprising the two transducers 5 and 6.

In another embodiment not represented, the miniature kinetic energy harvester 1 can comprise additional fingers with teeth on each side of the finger, and/or fingers with flat surfaces on each side of the finger.

In another embodiment not represented, the miniature kinetic energy harvester 1 can comprise fingers presenting on a same side, teeth on a first part of the length of the finger and a flat surface on a second part of the length of the finger.

Further, independently of the orientation of the teeth previously described, it is possible to have different alignments or misalignments of the fingers, as will be described hereafter in relation with figures 3 and 4.

On figure 3, we can see a first model hereafter named "model R" (for rotation), in which the comb structure of the two transducers 5, 6 are rotationally symmetric. In other words, the fingers 521 of the second comb electrode 52 are respectively aligned with the fingers 611 of the first comb electrode 61 but are shifted with the fingers 621 of the second comb 62. Further, the fingers 621 of the second comb-shaped electrode 62 of the second transducer 6 are aligned with the fingers 511 of the first comb-shaped electrode 51 of the first transducer 5.

Consequently, when the movable element 3 moves in the first sense Xa, in the first transducer 5, the teeth 522 of the second comb 52 come closer of the teeth 512 of the first comb 51, whereas in the second transducer 6, the flat surfaces 623 of the second comb 62 come closer of the flat surfaces 613 of the first comb 61.

The situation is reversed when the movable element 3 moves in the second sense Xb.

Thus, the capacitances corresponding to the maximum displacements in both senses Xa and Xb are the same.

On figure 4, we can see a second model, hereafter named "model M", (for mirror), in which the comb structure of the two transducers 5, 6 is a mirror-symmetric structure. In this model, the fingers 521 of the second comb 52 of the transducer 5 are respectively aligned with the fingers 621 of the second comb 62 of the transducer 6, whereas the fingers 511 of the first comb 51 of the transducer 5 are aligned with the fingers 611 of the first comb 61 of the transducer 6.

In other words, the movable element 3 is symmetric along its longitudinal axis parallel to the direction X.

Consequently, when the movable element 3 moves in the first sense Xa, in the first transducer 5 (and respectively in the second transducer 6) the teeth 522 (respectively 622) come closer of the teeth 512 (respectively 612). Due to the aerodynamic shape of the teeth, there is a strong decrease of air damping, the fingers and the teeth reach a small gap between them and thus a large maximum capacitance Cmax can be obtained.

To the contrary, when the movable element 3 moves in the second sense Xb, in the first transducer 5 (and respectively in the second transducer 6), the flat surfaces 523 (respectively 623) of the fingers 521 (respectively 621) come closer of the flat surfaces 513 (respectively 613) of the fingers 511 (respectively 611).

In this case, the air damping is the same as with a classic interdigitated comb.

It is to be noted that even if not represented on the figures, it could be possible to have the orientation of the teeth described in connection with figure 3a, 3b, 3c, but with the second fingers 521 and 621 aligned and with the first fingers 511 and 611 also aligned. Similarly, it could be possible to have the orientation of the teeth described on figure 4 but with a misalignment of the second fingers 521 and 621 and a misalignment of the first figures 511, 611.

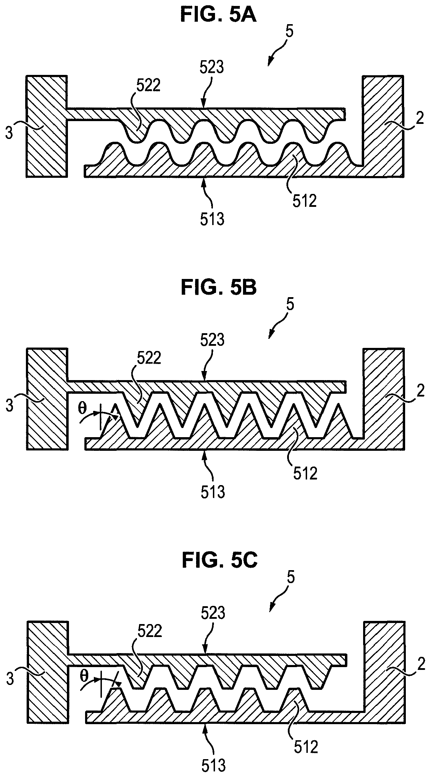

The shape of the teeth must be aerodynamic and can be chosen among a bump-shape, a triangular shape (preferably isosceles-triangle) or a trapezoidal shape as represented on figures 5a, 5b and 5c, or even a rectangular shape.

When the teeth are of triangular or trapezoidal shape, the key parameter for the teeth design is the angle θ which extends between the normal vector of the comb surface and the side face of a tooth of the comb, as shown in figures 5b and 5c.

Tests have been done with the two models M and R previously described and with a model G of the prior art in which comb-shaped electrodes are provided with interdigitated fingers but without teeth.

The capacitances of the entire devices are calculated in relation with the displacement of the movable element 3 and the angle θ, provided that the maximum displacement is identical on both senses Xa and Xb for all the three models. The design of the three models had the same area of the combs. The design rules consider the limitation of the deep etching process of silicon that the minimum dimension in the layout should be no less than 30 µm. The initial distance between the electrodes is fixed (70 µm) for easy comparison, and the same for the maximum displacement of the movable element defined by the initial gap between the elastic beams 71 and the stoppers 31 (66 µm, neglecting the deformation of elastic beams) for all the three designs.

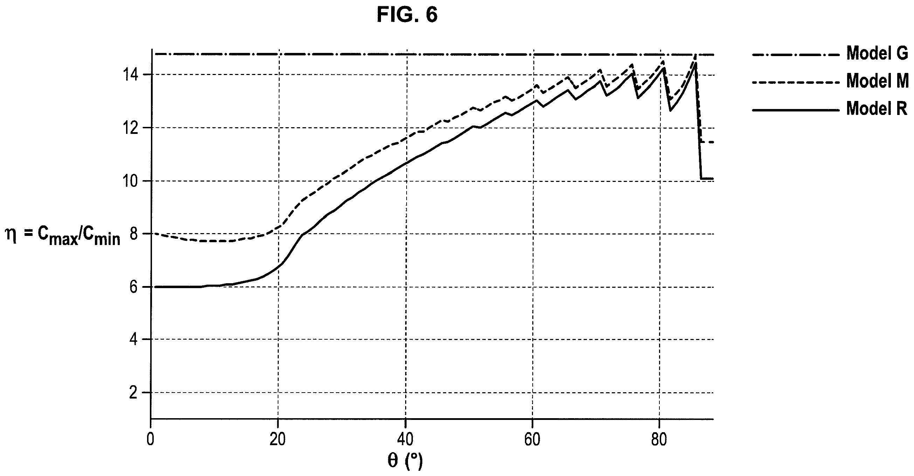

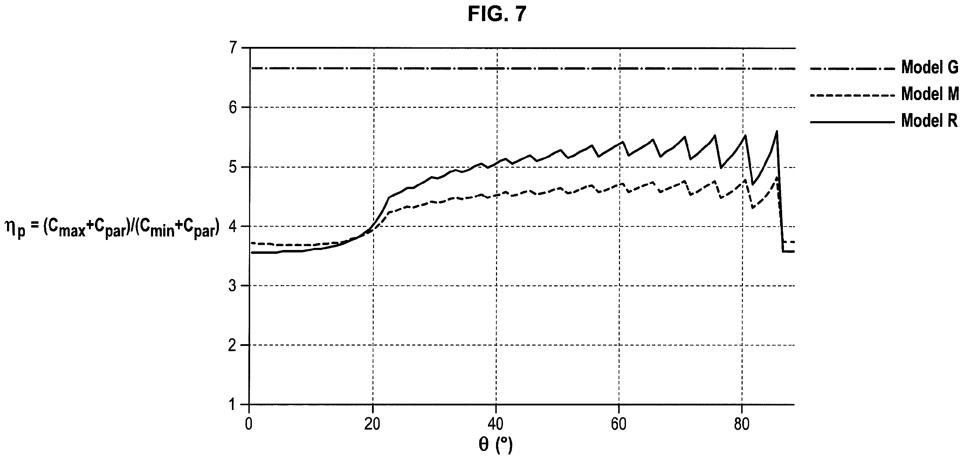

The capacitance ratio η and the one considering a parametric capacitance Cpar=28 pF from the package and the measurement electronics with η = Cmax/Cmin and ηₚ = (Cmax+Cpar)/(Cmin+Cpar) are calculated accordingly, and plotted in relation to angle θ as shown in figures 6 and 7.

The ratios provided by the calculations are applicable to the vacuum condition since the air damping is not taken into account. For model M, the maximum capacitances on the two senses Xa and Xb are not identical, the ratio is calculated with the mean value of the two maximum capacitances. According to the curves in figure 7, the largest ratio is achieved with the rotation-symmetry model R rather than with the model M.

The influence of angle θ on the capacitance ratio ηₚ acts on two aspects.

On the one hand, the increase of θ from 0° to 90°, firstly causes a decrease of the minimum gap between the electrodes, leading to an increased Cmax while this growth become negligible after θ exceeds 30°. On the other hand, the total width of each tooth grows with the growth of θ and the number of teeth on each comb decreases, causing a drop in the total capacitance. Having a small θ also improve the air damping reduction. θ is thus optimized between 5° and 60° and preferably between 22° and 30° where ηₚ reaches a maximum.

The miniature kinetic energy harvester according to the invention may be fabricated as a microelectromechanical system (MEMS) using batch fabrication technologies generally used for semiconductor devices. Alternatively, the miniature energy harvester could be made by laser machining of a metal plate, Focused Ion Beam Micromachining or 3D printing.

### EXPERIMENT

The capacitance variation of the three models G, M and R have been measured respectively with an acceleration of 2 gₚₑₐₖ at their resonance frequency (around 120 Hz) both in air (standard atmospheric pressure) and in vacuum (pressure <10⁻³ mbar), using the measuring technique described in the article of P Basset, D Galayko, F Cottone, R Guillemet, E Blokhina, F Marty, & T Bourouina, "Electrostatic vibration energy harvester with combined effect of electrical nonlinearities and mechanical impact" J. Micromech. and Microeng., 24(3), 035001, 2014.

In this technique, a high frequency (1k~100MHz) sinusoidal signal (i.e. the carrier signal) is applied to one electrode of a variable capacitor, the other electrode of which is grounded through a resistor. The phase difference between the two electrodes of the capacitor is measured. The dynamic value of the variable capacitor can be calculated in regard to the value of the resistor, the frequency of the carrier signal and the phase shift.

In the measurements, the frequency of the carrier signal is 100 kHz, while the optimal load resistance that offers the highest accuracy is 14.9kΩ. The capacitance ranges of the three models and the ratio η =Cmax/Cmin are listed in Table 1 below.

**Table 1**

| | Air | | | Vacuum | | |
|---|---|---|---|---|---|---|
| | Cmax | Cmin | η | Cmax | Cmin | η |
| Model G | 135 | 30 | 4.5 | 450 | 30 | 15 |
| Model R | 270 | 30 | 9 | 290 | 30 | 9.7 |
| Model M | 120 | 30 | 4 | 300 | 30 | 10 |

| | | | | | | |
|---|---|---|---|---|---|---|
| * Cₘₐₓ *values are the means of varied peak capacitances, parasitic capacitance Cₚₐᵣ=28 pF are removed from the measured results* | | | | | | |

It is shown that the highest ratio η in vacuum is reached by model G as expected by the theoretical calculation, while the one in standard atmospheric pressure is achieved by model R.

The measured capacitance in vacuum basically agrees with the results given by the theoretical calculation shown in figure 6, because the air damping effect is removed and the maximum displacement is easily predicted in the model according to the design. However, there is still a slight difference between the two results, which can be explained by the non-uniformity of the vertical layer of Parylene C covering the interdigitated electrodes.

In contrast, the devices working in air basically achieve a ratio η lower than that in vacuum, due to the air damping. It is observed that the influences of air damping are less significant in model R than that of the other two models G and M. This indicates that the hierarchical comb shape is helpful in reducing the air damping, which is partly caused by a reduced approaching velocity between the surfaces of the teeth on the two electrodes. The huge influence of the air damping in model M rather than in model R results from the symmetry in comb shape. In model M, the combs are all gap closing along one sense of displacement, bringing a large air damping effect as in model G. In contrast, the air damping effect in model R is always a combination between the damping in flat capacitors 9 and that in teeth capacitors 8, and is thus less significant.

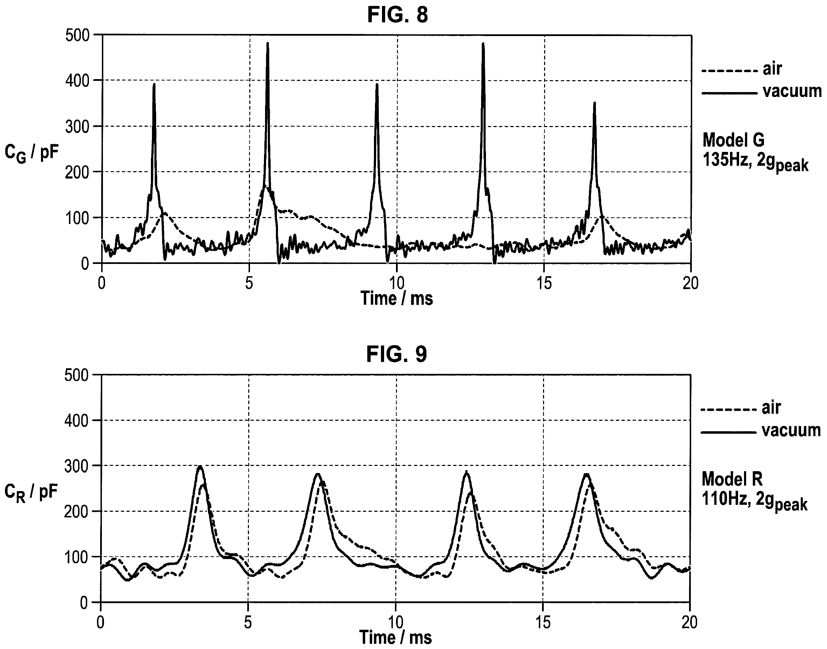

The transient variation of capacitances of models G and R are shown in figures 8 and 9, corresponding to the highest ratio of capacitive variation in air and in vacuum respectively. The air damping in model G is clearly influencing the capacitance variation behavior. Firstly, the peak capacitance in vacuum is higher than 3 times that in air, because the minimum gap reached without air damping is far lower than with the damping. Secondly, the time duration of each peak in air is much wider, which results from a lower velocity of the movable electrode approaching the fixed one in air, especially when the movable element 3 moves from the maximum displacement back to the balance point. Both the phenomena results from a huge air damping effect in model G. In contrast, the damping effect in model R is less significant: the difference of peak capacitance in air and vacuum is less than 10%, while the width of capacitance pulses are close to each other under the two pressure levels.

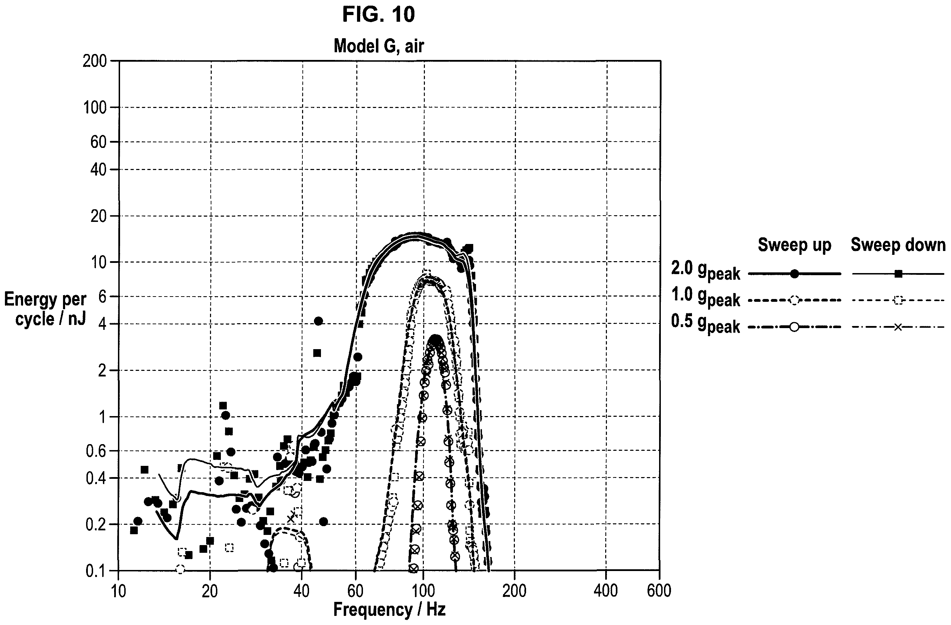

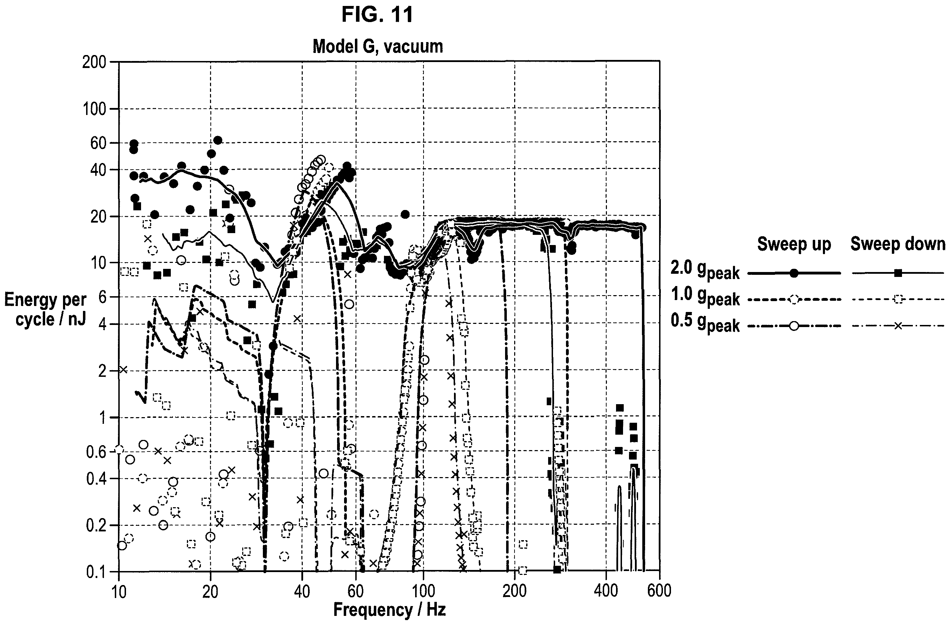

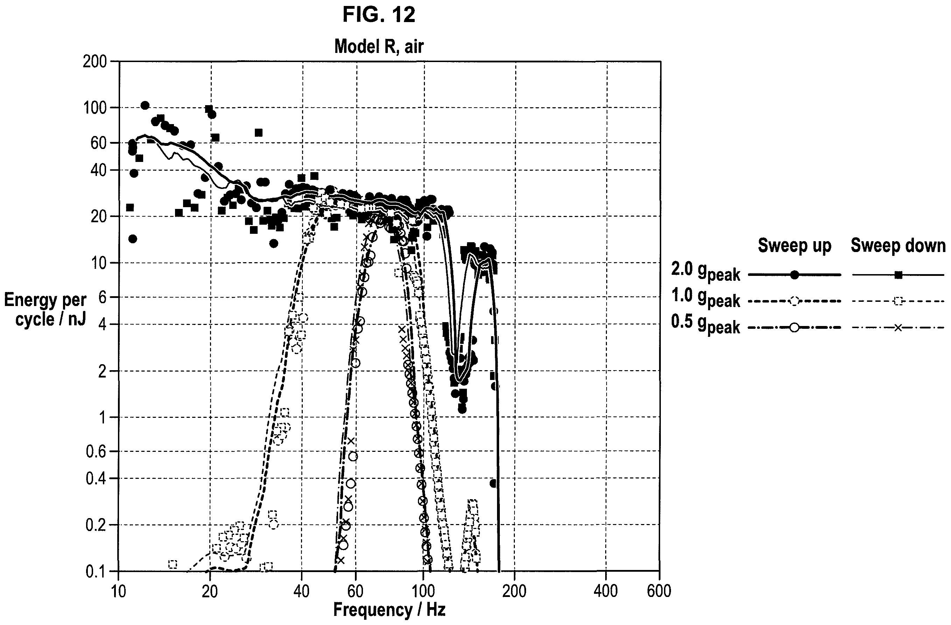

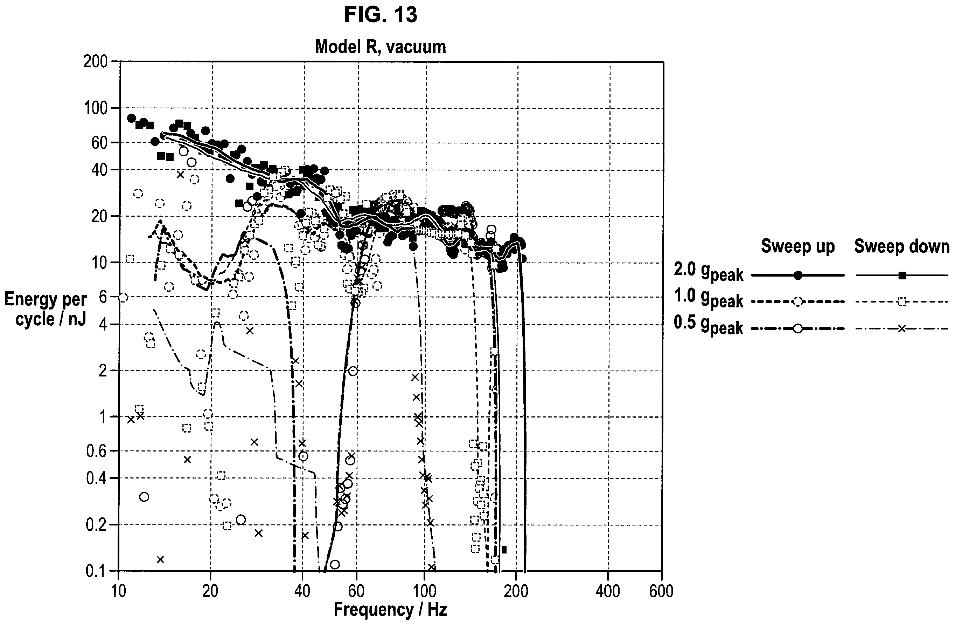

The output power of models G and R both in air and in vacuum are measured through frequency sweeps at 0.5, 1 and 2 gₚₑₐₖ of acceleration with the optimal load of 6.6Ω. Unlike the results listed in Table 1, the electronics for the power measurement brings the parasitic capacitance Cpar=28 pF as utilized in the simulation. The energy provided during each cycle of input acceleration is calculated by dividing the power by the frequency of mechanical excitation, and is shown in figures 10 to 13.

The performance of model G is narrow-banded in air, but greatly expanded in vacuum; in comparison, model R shows a larger bandwidth and a higher power capability in air than model G, while the bandwidth of model R with 2 gₚₑₐₖ in air and in vacuum are approximately equivalent. These confirm the drastic drop of air damping effect with the new hierarchical comb shape. Within low frequency range (10-40 Hz), the harvested energy increases with the drop of frequency in vacuum for both models and in air for model R at 2 gₚₑₐₖ, majorly due to the frequency up-conversion behavior, which occurs only when the air damping is low enough to allow impacts on the stoppers.

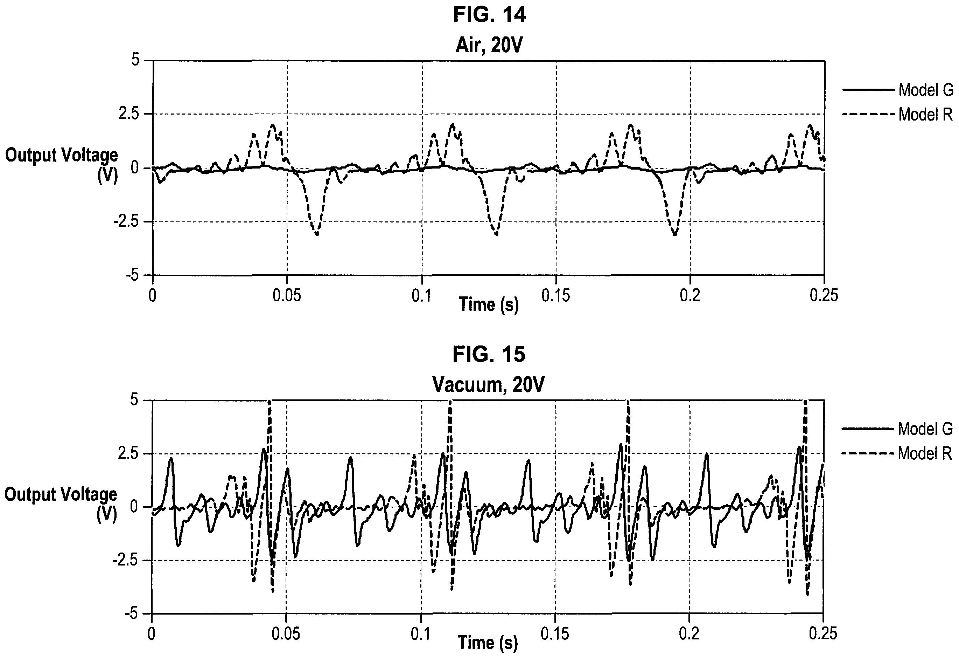

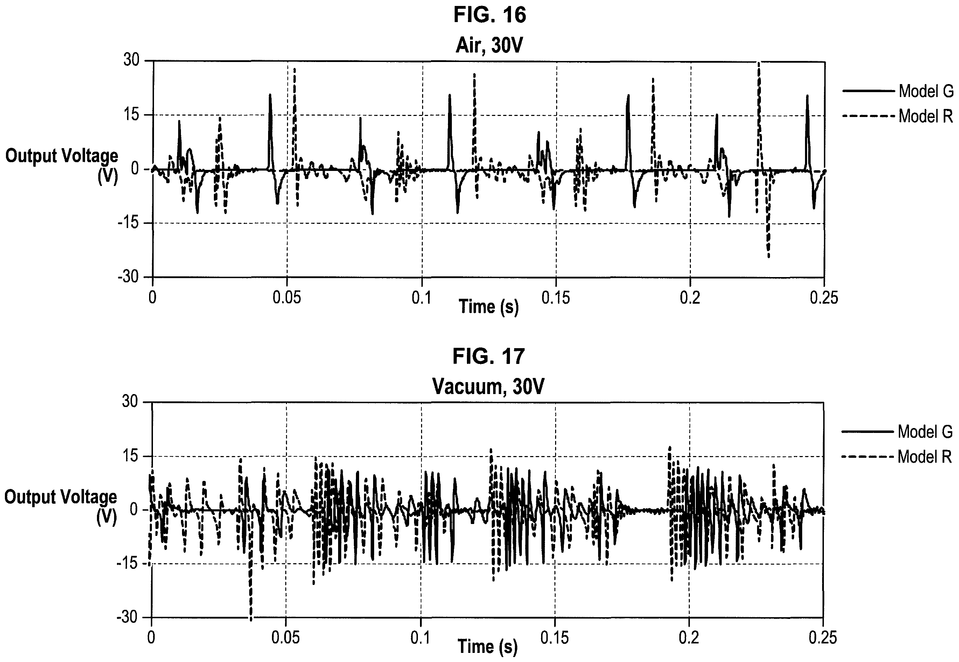

The low air damping effect in model R is further confirmed with the results shown in figures 14 to 17, where transient tests are performed with the device working at 15 Hz/2 gₚₑₐₖ loaded with a 6.6 MQ resistance: Basically the oscillation frequency of the output signals are higher than that of the input excitation due to the frequency-up mechanism. The output signals of model R has a higher amplitude, and the model allows more cycles of mechanical oscillation in air after each excitation, both caused by low air damping. When the bias voltage between the electrodes applied on the models increases from 20 V to 30 V, the amplitude of the output voltage and the oscillation frequency both increase as expected. The frequency of model G in air is much lower than that in vacuum, which also comes from the air damping. In contrast, the corresponding frequency drop from air damping in model R is negligible.

The energy harvested during each cycle of the mechanical excitation is calculated according to the transient signal, the load, and the excitation frequency. The energy collected by Model G at 20 V/30 V of bias are 0.13 nJ/39 nJ in air and 12 nJ/179 nJ in vacuum; while model R provides 11 nJ/158 nJ in air and 12 nJ/ 185 nJ in vacuum. Hence the proposed new shape of electrode improves the harvested energy by a maximum factor of 85 in air at low frequencies compared to classical gap-closing electrodes (model G).

All the above-mentioned experiments shows that the miniature kinetic energy harvester according to the invention effectively reduces the air damping effect in the device under normal air pressure. Even though the new comb shape cannot reach the ratio as high as that of the gap-closing structure (model G) in vacuum, its performance in air outperforms the gap-closing comb, reaching a higher amplitude and thus a larger ratio and a higher power output.

A rotation-symmetric model that achieves the best performance results from a trade-off between the requirements of lower air damping effect, higher ratio of capacitance variation, and larger number of combs.

The output power of the optimal model is improved in air especially within the low frequency range (20-40 Hz) at the acceleration of 2 gₚₑₐₖ, because the displacement of the movable element 3 is able to reach the maximum due to the frequency up-conversion behavior, and the air damping effect is negligible compared to the loss caused by the impacts.

Thus, the invention proposes a new hierarchical shape for the electrodes that drastically reduces the air damping and so significantly increases the harvested power at atmospheric pressure, which may avoid the use of a costly vacuum package.

A better aerodynamic profile is obtained with triangular teeth on the electrode's fingers compare to flat fingers (Model G). So this invention also proposes to have aerodynamic teeth only on one side of the finger's electrodes (Model R and Model M).

Symmetric repartition of the teeth as in Model M is less effective because full air damping as in Model G occurs once per mechanical oscillation (with model G, it happen twice per mechanical oscillation).

The asymmetric distribution between an aerodynamic profile like triangular teeth and flat electrodes, similarly to Model R is an optimum for producing electrical energy.

## Claims

1. A miniature kinetic energy harvester (1) for generating electrical energy, comprising:
- a support (2, 21, 22), a movable element (3), at least one spring (4) mounted between the movable element (3) and the support (2, 21, 22) so that the movable element (3) may be brought into oscillation relative to the support (2, 21, 22) according to at least one first direction (X) of oscillation,
- at least one electrostatic transducer (5, 6), arranged between the movable element (3) and the support (2),
the electrostatic transducer (5, 6) having a first comb-shaped electrode (51, 61) fixed to the support (2) and interdigitated with a second comb-shaped electrode (52, 62) fixed to the movable element (3),
the first fingers (511, 611) of the first comb-shaped electrode (51, 61) and the second fingers (521, 621) of the second comb-shaped electrode (52, 62) being alternatively arranged,
wherein at least some of the first fingers (511, 611) and at least some of the second fingers (521, 621) comprise :
- teeth (512, 612, 522, 622) on one finger side, said teeth (512, 612 ; 522, 622) extending parallel to said first direction (X) of oscillation,
- a flat surface (513, 613 ; 523, 623) on the opposite finger side, and wherein these first fingers (511, 611) and these second fingers (521, 621) are disposed such that in the electrostatic transducer (5, 6), the teeth (512, 612) of these first fingers (511, 611) are interdigitated with the teeth (522, 622) of these second fingers (521, 621) to form teeth capacitors (8) between said first fingers and second fingers, and **characterized in that** the flat surfaces (513, 613) of these first fingers (511, 611) face the flat surfaces (523,623) of these second fingers (521, 621) to form flat capacitors (9) between said first fingers and second fingers, in order to generate electrical energy with teeth capacitors (8) and flat capacitors (9) by variation of the capacitance of the miniature kinetic energy harvester.

2. The miniature kinetic energy harvester according to claim 1, wherein the teeth (512, 612, 522, 622) are aerodynamically shaped to reduce air damping dissipation when the teeth (512, 612) of the first fingers (511, 611) of the first comb-shaped electrode (51, 61) come closer to the teeth (522, 622) of the second fingers (521, 621) of the second comb-shaped electrode (52, 62).

3. The miniature kinetic energy harvester according to any one of the preceding claims, the movable element (3) being displaced between two positions, wherein the teeth of the first fingers (511, 611) and the teeth of the second fingers (521, 621) are disposed in the energy harvester such that 50% of teeth capacitors (8) and 50% of flat capacitors (9) control the variation of the capacitance of the miniature kinetic energy harvester , in each of the two positions of the movable element (3) in regard to the support (2, 21, 22).

4. The miniature kinetic energy harvester according to any one of the preceding claims, comprises two electrostatic transducers (5, 6), a first transducer (5) disposed on one edge of the movable element (3) and a second transducer (6) disposed on the opposite edge of the movable element (3), said both edges of the movable element (3) being parallel to the first direction (X) of oscillation.

5. The miniature kinetic energy harvester according to any of the precedent claims, wherein the first fingers (511, 611) and the second fingers (521, 621) extend perpendicularly relative to the direction (X) of oscillation.

6. The miniature kinetic energy harvester according to claims 4 and 5, wherein, for the movable element (3), the teeth (522) of the second fingers (521) of the first transducer (5) are oriented in a first sense (Xa) and the teeth (622) of the second fingers (621) of the second transducer (6) are oriented in a second sense (Xb), opposite to the first sense (Xa), and for the support (2, 21, 22), the teeth (512) of the first fingers (511) of the first transducer (5) are oriented in said second sense (Xb) and the teeth (612) of the first fingers (611) of the second transducer (6) are oriented in said first sense (Xa), in order to have 50% of teeth capacitors (8) and 50 % of flat capacitors (9) in the first sense Xa and in the second sense Xb of the oscillation of the movable element (3).

7. The miniature kinetic energy harvester according to claims 4 and 5, wherein for the movable element (3), the teeth (522) of the second fingers (521) of the first transducer (5) are oriented in the same first sense (Xa) as the teeth (622) of the second fingers (621) of the second transducer (6) and for the support (2, 21, 22), the teeth (512) of the first fingers (511) of the first transducer (5) are oriented in the same second sense (Xb), opposite to the first sense (Xa), as the teeth (612) of the first fingers (611) of the second transducer (6), in order to have 100% of teeth capacitors (8) in said first sense (Xa) of oscillation of the movable element (3) and 100% of flat capacitors (9) in said second sense (Xb) of oscillation of the movable element (3).

8. The miniature kinetic energy harvester according to any one of the preceding claims, wherein the teeth (512, 612, 522, 622) have the shape of a triangle, a trapezoid, a rectangle or a bump.

9. The miniature kinetic energy harvester according to claim 8, wherein the triangle or the trapezoid is isosceles and the angle (Θ) between the symmetrical axis of the teeth (512, 612, 522, 622) and one of its isosceles sides is comprised between 5° and 60°.

10. The miniature kinetic energy harvester according to claim 8, wherein the triangle or the trapezoid is isosceles and the angle (Θ) between the symmetrical axis of the teeth (512, 612, 522, 622) and one of its isosceles sides is comprised between 22° and 30°.

11. The miniature kinetic energy harvester according to any one of the preceding claims, wherein the transducer (5, 6) is a MEMS transducer.

12. The miniature kinetic energy harvester according to any one of the preceding claims, wherein the support (2) surrounds the movable element (3).

13. The miniature kinetic energy harvester according to any one of the preceding claims, wherein the harvester comprises also additional fingers with teeth on each side of the additional finger, and/or additional fingers with flat surfaces on each side of the additional finger.

14. The miniature kinetic energy harvester according to any one of the preceding claims, wherein the harvester comprises also additional fingers with teeth and flat surface on the same side of the additional finger.

15. The miniature kinetic energy harvester according to any one of the preceding claims 4-14, wherein for the movable element (3), the teeth (522) of the second fingers (521) of the first transducer (5) are oriented in a first sense (Xa) and the teeth (622) of the second fingers (621) of the second transducer (6) are oriented in a second sense (Xb), opposite to the first sense (Xa), and for the support (2, 21, 22), the teeth (512) of the first fingers (511) of the first transducer (5) are oriented in said second sense (Xb) and the teeth (612) of the first fingers (611) of the second transducer (6) are oriented in said first sense (Xa), in order to have x% of teeth capacitors (8) and y % of flat capacitors (9) in the first sense Xa and in the second sense Xb of the oscillation of the movable element (3), with x and y taking a value in the interval of 0% to 100%, and the sum of x and y is equal to 100% for the energy harvester.

16. The miniature kinetic energy harvester according to any one of the preceding claims 1-15, the movable element (3) being displaced between two positions, wherein the teeth of first fingers and the teeth of the second fingers are disposed in the energy harvester such that: x% of teeth capacitors (8) and y% of flat capacitors (9) control the variation of the capacitance of the miniature kinetic energy harvester , in each of the two positions of the movable element (3) in regard to the support (2, 21, 22), and the sum of x and y is equal to 100% for the energy harvester.

## Patentansprüche

1. Miniatur-Bewegungsenergie-Harvester (1) zum Erzeugen von elektrischer Energie, umfassend:
- einen Träger (2, 21, 22), ein bewegliches Element (3), mindestens eine Feder (4), die so zwischen dem beweglichen Element (3) und dem Träger (2, 21, 22) montiert ist, dass das bewegliche Element (3) in Bezug auf den Träger (2, 21, 22) gemäß mindestens einer ersten Schwingungsrichtung (X) in Schwingung versetzt werden kann,
- mindestens einen elektrostatischen Wandler (5, 6), der zwischen dem beweglichen Element (3) und dem Träger (2) angeordnet ist,
wobei der elektrostatische Wandler (5, 6) eine erste kammförmige Elektrode (51, 61) aufweist, die am Träger (2) fixiert ist und mit einer zweiten kammförmigen Elektrode (52, 62), die am beweglichen Element (3) fixiert ist, in Eingriff steht,
wobei die ersten Finger (511, 611) der ersten kammförmigen Elektrode (51, 61) und die zweiten Finger (521, 621) der zweiten kammförmigen Elektrode (52, 62) abwechselnd angeordnet sind,
wobei wenigstens einige der ersten Finger (511, 611) und wenigstens einige der zweiten Finger (521, 621) umfassen:
- Zähne (512, 612, 522, 622) auf einer Fingerseite, wobei die Zähne (512, 612; 522, 622) sich parallel zur ersten Schwingungsrichtung (X) erstrecken,
- eine flache Oberfläche (513, 613 ; 523, 623) auf der gegenüberliegenden Fingerseite,
und wobei diese ersten Finger (511, 611) und diese zweiten Finger (521, 621) derart angeordnet sind, dass im elektrostatischen Wandler (5, 6) die Zähne (512, 612) dieser ersten Finger (511, 611) mit den Zähnen (522, 622) dieser zweiten Finger (521, 621) in Eingriff stehen, um Zahnkondensatoren (8) zwischen den ersten und den zweiten Fingern zu bilden,
und **dadurch gekennzeichnet, dass** die
flachen Oberflächen (513, 613) dieser ersten Finger (511, 611) den flachen Oberflächen (523,623) dieser zweiten Finger (521, 621) gegenüberliegen, um Flachkondensatoren (9) zwischen den ersten Fingern und den zweiten Fingern zu bilden, um elektrische Energie mit den Zahnkondensatoren (8) und den flachen Kondensatoren (9) durch eine Änderung der Kapazität des Miniatur-Bewegungsenergie-Harvesters zu erzeugen.

2. Miniatur-Bewegungsenergie-Harvester nach Anspruch 1, wobei die Zähne (512, 612, 522, 622) aerodynamisch geformt sind, um Luftdämpfungsdissipation zu reduzieren, wenn die Zähne (512, 612) der ersten Finger (511, 611) der ersten kammförmigen Elektrode (51, 61) sich den Zähnen (522, 622) der zweiten Finger (521, 621) der zweiten kammförmigen Elektrode (52, 62) nähern.

3. Miniatur-Bewegungsenergie-Harvester nach einem der vorhergehenden Ansprüche, wobei das bewegliche Element (3) zwischen zwei Stellungen verschoben wird, wobei die Zähne der ersten Finger (511, 611) und die Zähne der zweiten Finger (521, 621) im Energie-Harvester derart angeordnet sind, dass in jeder der zwei Stellungen des beweglichen Elements (3) in Bezug auf den Träger (2, 21, 22) 50 % der Zahnkondensatoren (8) und 50 % der Flachkondensatoren (9) die Änderung der Kapazität des Miniatur-Bewegungsenergie-Harvesters steuern.

4. Miniatur-Bewegungsenergie-Harvester nach einem der vorhergehenden Ansprüche, umfassend zwei elektrostatische Wandler (5, 6), wobei ein erster Wandler (5) an einer Kante des beweglichen Elements (3) angeordnet ist, und ein zweiter Wandler (6) an der gegenüberliegenden Kante des beweglichen Elements (3) angeordnet ist, wobei beide Kanten des beweglichen Element (3) parallel zur ersten Schwingungsrichtung (X) sind.

5. Miniatur-Bewegungsenergie-Harvester nach einem der vorhergehenden Ansprüche, wobei die ersten Finger (511, 611) und die zweiten Finger (521, 621) sich in Bezug auf die Schwingungsrichtung (X) senkrecht erstrecken.

6. Miniatur-Bewegungsenergie-Harvester nach Anspruch 4 und 5, wobei für das bewegliche Element (3) die Zähne (522) der zweiten Finger (521) des ersten Wandlers (5) in einer ersten Richtung (Xa) orientiert sind und die Zähne (622) der zweiten Finger (621) des zweiten Wandlers (6) in einer zweiten Richtung (Xb) entgegengesetzt zur ersten Richtung (Xa) orientiert sind, und für den Träger (2, 21, 22) die Zähne (512) der ersten Finger (511) des ersten Wandlers (5) in der zweiten Richtung (Xb) orientiert sind und die Zähne (612) der ersten Finger (611) des zweiten Wandlers (6) in der ersten Richtung (Xa) orientiert sind, um 50 % der Zahnkondensatoren (8) und 50 % der Flachkondensatoren (9) in der ersten Richtung Xa und in der zweiten Richtung Xb der Schwingung des beweglichen Elements (3) aufzuweisen.

7. Miniatur-Bewegungsenergie-Harvester nach Anspruch 4 und 5, wobei für das bewegliche Element (3) die Zähne (522) der zweiten Finger (521) des ersten Wandlers (5) in der gleichen ersten Richtung (Xa) wie die Zähne (622) der zweiten Finger (621) des zweiten Wandlers (6) orientiert sind, und für den Träger (2, 21, 22) die Zähne (512) der ersten Finger (511) des ersten Wandlers (5) in der gleichen zweiten Richtung (Xb) entgegengesetzt zur ersten Richtung (Xa) wie die Zähne (612) der ersten Finger (611) des zweiten Wandlers (6) orientiert sind, um 100 % der Zahnkondensatoren (8) in der ersten Richtung (Xa) der Schwingung des beweglichen Elements (3) und 100 % der Flachkondensatoren (9) in der zweiten Richtung (Xb) der Schwingung des beweglichen Elements (3) aufzuweisen.

8. Miniatur-Bewegungsenergie-Harvester nach einem der vorhergehenden Ansprüche, wobei die Zähne (512, 612, 522, 622) die Form eines Dreiecks, eines Trapezes, eines Rechtecks oder eines Höckers aufweisen.

9. Miniatur-Bewegungsenergie-Harvester nach Anspruch 8, wobei das Dreieck oder das Trapez gleichschenklig ist, und der Winkel (Θ) zwischen den Symmetrieachsen der Zähne (512, 612, 522, 622) und einer seiner gleichschenkligen Seiten zwischen 5° und 60° liegt.

10. Miniatur-Bewegungsenergie-Harvester nach Anspruch 8, wobei das Dreieck oder das Trapez gleichschenklig ist, und der Winkel (Θ) zwischen den Symmetrieachsen der Zähne (512, 612, 522, 622) und einer seiner gleichschenkligen Seite zwischen 22° und 30° liegt.

11. Miniatur-Bewegungsenergie-Harvester nach einem der vorhergehenden Ansprüche, wobei der Wandler (5, 6) ein MEMS-Wandler ist.

12. Miniatur-Bewegungsenergie-Harvester nach einem der vorhergehenden Ansprüche, wobei der Träger (2) das bewegliche Element (3) umgibt.

13. Miniatur-Bewegungsenergie-Harvester nach einem der vorhergehenden Ansprüche, wobei der Harvester außerdem zusätzliche Finger mit Zähnen auf jeder Seite des zusätzlichen Fingers und/oder zusätzliche Finger mit flachen Oberflächen auf jeder Seite des zusätzlichen Fingers umfasst.

14. Miniatur-Bewegungsenergie-Harvester nach einem der vorhergehenden Ansprüche, wobei der Harvester außerdem zusätzliche Finger mit Zähnen und einer flachen Oberfläche auf der gleichen Seite des zusätzlichen Fingers umfasst.

15. Miniatur-Bewegungsenergie-Harvester nach einem der Ansprüche 4 bis 14, wobei für das bewegliche Element (3) die Zähne (522) der zweiten Finger (521) des ersten Wandlers (5) in einer ersten Richtung (Xa) orientiert sind und die Zähne (622) der zweiten Finger (621) des zweiten Wandlers (6) in einer zweiten Richtung (Xb) entgegengesetzt zur ersten Richtung (Xa) orientiert sind, und für den Träger (2, 21, 22) die Zähne (512) der ersten Finger (511) des ersten Wandlers (5) in der zweiten Richtung (Xb) orientiert sind und die Zähne (612) der ersten Finger (611) des zweiten Wandlers (6) in der ersten Richtung (Xa) orientiert sind, um x % der Zahnkondensatoren (8) und y % der Flachkondensatoren (9) in der ersten Richtung Xa und in der zweiten Richtung Xb der Schwingung des beweglichen Elements (3) aufzuweisen, wobei x und y einen Wert im Intervall von 0 % bis 100 % annehmen, und die Summe von x und y gleich 100 % für den Energie-Harvester ist.

16. Miniatur-Bewegungsenergie-Harvester nach einem der vorhergehenden Ansprüche 1 bis 15, wobei das bewegliche Element (3) zwischen zwei Stellungen verschoben wird, wobei die Zähne der ersten Finger und die Zähne der zweiten Finger im Energie-Harvester derart angeordnet sind, dass: in jeder der zwei Stellungen des beweglichen Elements (3) in Bezug auf den Träger (2, 21, 22) x % der Zahnkondensatoren (8) und y % der Flachkondensatoren (9) die Änderung der Kapazität des Miniatur-Bewegungsenergie-Harvesters steuern, und die Summe von x und y gleich 100 % für den Energie-Harvester ist.

## Revendications

1. Collecteur d'énergie cinétique miniature (1) pour générer une énergie électrique, comprenant :
- un support (2, 21, 22), un élément mobile (3), au moins un ressort (4) monté entre l'élément mobile (3) et le support (2, 21, 22) de sorte que l'élément mobile (3) puisse être mis en oscillation par rapport au support (2, 21, 22) conformément à au moins une première direction (X) d'oscillation,
- au moins un transducteur électrostatique (5, 6), agencé entre l'élément mobile (3) et le support (2),
le transducteur électrostatique (5, 6) ayant une première électrode en forme de peigne (51, 61) fixée au support (2) et interdigitée avec une deuxième électrode en forme de peigne (52, 62) fixée à l'élément mobile (3),
les premiers doigts (511, 611) de la première électrode en forme de peigne (51, 61) et les deuxièmes doigts (521, 621) de la deuxième électrode en forme de peigne (52, 62) étant agencés alternativement,
dans lequel au moins certains des premiers doigts (511, 611) et au moins certains des deuxièmes doigts (521, 621) comprennent :
- des dents (512, 612, 522, 622) d'un côté du doigt, lesdites dents (512, 612 ; 522, 622) s'étendant parallèlement à ladite première direction (X) d'oscillation,
- une surface plate (513, 613 ; 523, 623) du côté opposé du doigt,
et dans lequel ces premiers doigts (511, 611) et ces deuxièmes doigts (521, 621) sont disposés de sorte que, dans le transducteur électrostatique (5, 6), les dents (512, 612) de ces premiers doigts (511, 611) soient interdigitées avec les dents (522, 622) de ces deuxièmes doigts (521, 621) pour former des condensateurs de dents (8) entre lesdits premiers doigts et deuxièmes doigts,
et **caractérisé en ce que** les surfaces plates (513, 613) de ces premiers doigts (511, 611) font face aux surfaces plates (523, 623) de ces deuxièmes doigts (521, 621) pour former des condensateurs plats (9) entre lesdits premiers doigts et deuxièmes doigts, afin de générer une énergie électrique avec les condensateurs de dents (8) et les condensateurs plats (9) par une variation de la capacitance du collecteur d'énergie cinétique miniature.

2. Collecteur d'énergie cinétique miniature selon la revendication 1, dans lequel les dents (512, 612, 522, 622) sont formées de manière aérodynamique pour réduire la dissipation par amortissement de l'air lorsque les dents (512, 612) des premiers doigts (511, 611) de la première électrode en forme de peigne (51, 61) se rapprochent des dents (522, 622) des deuxièmes doigts (521, 621) de la deuxième électrode en forme de peigne (52, 62).

3. Collecteur d'énergie cinétique miniature selon l'une quelconque des revendications précédentes, l'élément mobile (3) étant déplacé entre deux positions, dans lequel les dents des premiers doigts (511, 611) et les dents des deuxièmes doigts (521, 621) sont disposées dans le collecteur d'énergie de sorte que 50 % des condensateurs de dents (8) et 50 % des condensateurs plats (9) commandent la variation de la capacitance du collecteur d'énergie cinétique miniature, dans chacune des deux positions de l'élément mobile (3) par rapport au support (2, 21, 22).

4. Collecteur d'énergie cinétique miniature selon l'une quelconque des revendications précédentes, comprenant deux transducteurs électrostatiques (5, 6), un premier transducteur (5) disposé sur un bord de l'élément mobile (3) et un deuxième transducteur (6) disposé sur le bord opposé de l'élément mobile (3), lesdits deux bords de l'élément mobile (3) étant parallèles à la première direction (X) d'oscillation.

5. Collecteur d'énergie cinétique miniature selon l'une quelconque des revendications précédentes, dans lequel les premiers doigts (511, 611) et les deuxièmes doigts (521, 621) s'étendent perpendiculairement à la direction (X) d'oscillation.

6. Collecteur d'énergie cinétique miniature selon les revendications 4 et 5, dans lequel, pour l'élément mobile (3), les dents (522) des deuxièmes doigts (521) du premier transducteur (5) sont orientées dans un premier sens (Xa) et les dents (622) des deuxièmes doigts (621) du deuxième transducteur (6) sont orientées dans un deuxième sens (Xb), opposé au premier sens (Xa), et pour le support (2, 21, 22), les dents (512) des premiers doigts (511) du premier transducteur (5) sont orientées dans ledit deuxième sens (Xb) et les dents (612) des premiers doigts (611) du deuxième transducteur (6) sont orientées dans ledit premier sens (Xa), afin d'avoir 50 % des condensateurs de dents (8) et 50 % des condensateurs plats (9) dans le premier sens Xa et dans le deuxième sens Xb de l'oscillation de l'élément mobile (3) .

7. Collecteur d'énergie cinétique miniature selon les revendications 4 et 5, dans lequel, pour l'élément mobile (3), les dents (522) des deuxièmes doigts (521) du premier transducteur (5) sont orientées dans le même premier sens (Xa) que les dents (622) des deuxièmes doigts (621) du deuxième transducteur (6) et, pour le support (2, 21, 22), les dents (512) des premiers doigts (511) du premier transducteur (5) sont orientées dans le même deuxième sens (Xb), opposé au premier sens (Xa), que les dents (612) des premiers doigts (611) du deuxième transducteur (6), afin d'avoir 100 % des condensateurs de dents (8) dans ledit premier sens (Xa) d'oscillation de l'élément mobile (3) et 100 % des condensateurs plats (9) dans ledit deuxième sens (Xb) d'oscillation de l'élément mobile (3).

8. Collecteur d'énergie cinétique miniature selon l'une quelconque des revendications précédentes, dans lequel les dents (512, 612, 522, 622) ont la forme d'un triangle, d'un trapèze, d'un rectangle ou d'un bossage.

9. Collecteur d'énergie cinétique miniature selon la revendication 8, dans lequel le triangle ou le trapèze est isocèle et l'angle (Θ) entre l'axe de symétrie des dents (512, 612, 522, 622) et l'un de ses côtés isocèles est compris entre 5° et 60°.

10. Collecteur d'énergie cinétique miniature selon la revendication 8, dans lequel le triangle ou le trapèze est isocèle et l'angle (Θ) entre l'axe de symétrie des dents (512, 612, 522, 622) et l'un de ses côtés isocèles est compris entre 22° et 30°.

11. Collecteur d'énergie cinétique miniature selon l'une quelconque des revendications précédentes, dans lequel le transducteur (5, 6) est un transducteur MEMS.

12. Collecteur d'énergie cinétique miniature selon l'une quelconque des revendications précédentes, dans lequel le support (2) entoure l'élément mobile (3).

13. Collecteur d'énergie cinétique miniature selon l'une quelconque des revendications précédentes, dans lequel le collecteur comprend également des doigts supplémentaires avec des dents sur chaque côté du doigt supplémentaire, et/ou des doigts supplémentaires avec des surfaces plates sur chaque côté du doigt supplémentaire.

14. Collecteur d'énergie cinétique miniature selon l'une quelconque des revendications précédentes, dans lequel le collecteur comprend également des doigts supplémentaires avec des dents et une surface plate sur le même côté du doigt supplémentaire.

15. Collecteur d'énergie cinétique miniature selon l'une quelconque des revendications 4 à 14 précédentes, dans lequel, pour l'élément mobile (3), les dents (522) des deuxièmes doigts (521) du premier transducteur (5) sont orientées dans un premier sens (Xa) et les dents (622) des deuxièmes doigts (621) du deuxième transducteur (6) sont orientées dans un deuxième sens (Xb), opposé au premier sens (Xa), et pour le support (2, 21, 22), les dents (512) des premiers doigts (511) du premier transducteur (5) sont orientées dans ledit deuxième sens (Xb) et les dents (612) des premiers doigts (611) du deuxième transducteur (6) sont orientées dans ledit premier sens (Xa), afin d'avoir x % des condensateurs de dents (8) et y % des condensateurs plats (9) dans le premier sens Xa et dans le deuxième sens Xb de l'oscillation de l'élément mobile (3), x et y prenant une valeur dans l'intervalle de 0 % à 100 %, et que la somme de x et y soit égale à 100 % pour le collecteur d'énergie.

16. Collecteur d'énergie cinétique miniature selon l'une quelconque des revendications 1 à 15 précédentes, l'élément mobile (3) étant déplacé entre deux positions, dans lequel les dents des premiers doigts et les dents des deuxièmes doigts sont disposées dans le collecteur d'énergie de sorte que : x % des condensateurs de dents (8) et y % des condensateurs plats (9) commandent la variation de la capacitance du collecteur d'énergie cinétique miniature, dans chacune des deux positions de l'élément mobile (3) par rapport au support (2, 21, 22), et que la somme de x et y soit égale à 100 % pour le collecteur d'énergie.
